# EUROPÄISCHE PATENTANMELDUNG

(11) **EP 3 018 703 A1**
(43) Veröffentlichungstag der Anmeldung: **11.05.2016**
(21) Anmeldenummer: 14192120.5
(22) Anmeldetag: 06.11.2014
(51) Int. Cl.: H01L 21/67

(54) **Vorrichtung zum Aufbringen einer Folie auf einem Substrat**

(71) Anmelder: mechatronic Systemtechnik GmbH, 9500 Villach (AT)
(72) Erfinder: Oremus, Alexander, 9500 Villach (AT); Meinen, Tomas, 82049 Pullach im Isartal (DE); Truppe, Wolfgang, 9181 Feistritz im Rosental (AT); Götzenbrucker, Gerald, 9500 Villach, Osterreich (AT); Truppe, Wolfgang, 9181 Feistritz im Rosental, Osterreich (AT)
(74) Vertreter: Müller & Schubert

(57) **Zusammenfassung**

Die vorliegende Erfindung betrifft eine Vorrichtung (10) zum Aufbringen einer Folie auf einem Substrat. Um eine solche Vorrichtung bereitzustellen, die konstruktiv einfach ausgestaltet ist, und die zudem kostengünstig das Aufbringen einer Folie auf einem Substrat ermöglicht, ist erfindungsgemäß vorgesehen, dass die Vorrichtung (10) folgende Merkmale aufweist: eine Rahmenkomponente (20), die derart bereitgestellt ist, dass die Rahmenkomponente (20) in der Lage ist, mit der aufzubringenden Folie (90) zusammenzuwirken, eine Widerlagerkomponente (30), die derart bereitgestellt ist, dass sie in der Lage ist, ein Widerlager für die Rahmenkomponente (20) zu bilden oder eine Widerlagerfunktion in Bezug auf die Rahmenkomponente (20) auszuüben, sowie eine Federkomponente (40), die derart bereitgestellt ist, dass sie in der Lage ist, in Bezug auf die Rahmenkomponente (20) eine elastische Rückstellkraft (R) auszuüben. Weiterhin betrifft die vorliegende Erfindung eine Vorrichtung zum Bearbeiten eines Substrats sowie ein Verfahren zum Aufbringen einer Folie auf einem Substrat.

## Beschreibung

Die vorliegende Erfindung betrifft zunächst eine Vorrichtung zum Aufbringen einer Folie auf einem Substrat. Weiterhin betrifft die vorliegende Erfindung eine Vorrichtung zum Bearbeiten eines Substrats sowie ein Verfahren zum Aufbringen einer Folie auf einem Substrat.

Das Aufbringen von Folien auf Substraten ist bereits seit langem bekannt und findet Anwendung in den unterschiedlichsten technischen Gebieten.

Ein solches technisches Gebiet, bei dem Folien auf Substrate aufgebracht werden, stellt die Herstellung und Bearbeitung von Substraten in Form von Wafern dar. Ein Wafer ist grundsätzlich eine kreisrunde oder viereckige Scheibe, auf der sich elektronische Bauelemente befinden.

Während der Bearbeitung solcher Wafer befinden sich diese nicht selten auf beziehungsweise in einer Bearbeitungsvorrichtung, die beispielswiese einen Bearbeitungstisch aufweisen kann. Während der Bearbeitung der Wafer sind diese auf dem Bearbeitungstisch angeordnet, an dem sie, beispielsweise mittels Vakuum, angesaugt werden oder sind.

In der DE 11 2006 001 777 T5 beispielsweise ist eine solche Bearbeitungsvorrichtung für Wafer beschrieben, die einen Bearbeitungstisch in Form eines Folienaufklebetisches aufweist. Dieser bekannte Folienaufklebetisch besteht aus einem inneren Tisch, auf dem der zu bearbeitende Wafer angeordnet ist, sowie einem den inneren Tisch umgebenden äußeren Tisch. Der innere Tisch und/oder der äußere Tisch können in der Vertikalrichtung beweglich vorgesehen sein, wobei diese vertikale Beweglichkeit mittels geeigneter Manipulatoren erfolgt. Damit ist der Folienklebetisch dieser bekannten Lösung zum Einstellen einer Niveauposition entsprechend der Dicke der aufzuklebenden Folie und/oder des zu beklebenden Wafers geeignet. Um dies zu realisieren, wird mittels des Manipulators beziehungsweise der Manipulatoren der innere Tisch und/oder der äußere Tisch verfahren. Das Aufkleben der Folie auf dem Wafer erfolgt unter Zuhilfenahme einer Druckrolle. Diese Druckrolle überträgt eine Druckkraft auf die Folie, wodurch die Folie gegen den Wafer gedrückt und auf diesem aufgeklebt wird.

Die bekannte Lösung weist jedoch eine Reihe von Nachteilen auf. Zunächst ist die Lösung konstruktiv aufwändig, da zum verfahren des inneren Tischs oder des äußeren Tischs jeweils Manipulatoren erforderlich sind, bei denen es sich um zusätzliche Bauteile handelt. Zudem müssen diese Manipulatoren über einen geeigneten Antrieb verfügen. Dieser Antrieb stellt ein weiteres erforderliches Bauteil dar. Darüber hinaus muss der Antrieb in geeigneter Weise angesteuert werden, wozu eine zusätzliche Steuereinrichtung erforderlich ist. Weiterhin muss für den Tisch ein Messverfahren implementiert werden, der die Höhe des Wafers auf dem inneren Tisch genau bestimmt, damit die zu beklebende Oberfläche des Wafers durch ein Verfahren des inneren und/oder äußeren Tischs auf dasselbe Niveau gebracht werden kann wie die obere Oberfläche des äußeren Tischs.

Die Aufgabe der vorliegenden Erfindung besteht deshalb darin, eine Vorrichtung zum Aufbringen einer Folie auf einem Substrat sowie eine Bearbeitungsvorrichtung zum Bearbeiten eines Substrats bereitzustellen, die konstruktiv einfach ausgestaltet ist, und die zudem kostengünstig das Aufbringen einer Folie auf einem Substrat ermöglicht. Weiterhin soll ein entsprechend einfach gestaltetes Verfahren zum Aufbringen einer Folie auf ein Substrat bereitgestellt werden.

Diese Aufgabe wird erfindungsgemäß gelöst durch die Vorrichtung für das Aufbringen einer Folie auf ein Substrat, die nachfolgend auch als Aufbringvorrichtung bezeichnet wird, mit den Merkmalen gemäß dem unabhängigen Patentanspruch 1, die Bearbeitungsvorrichtung zum Bearbeiten eines Substrats mit den Merkmalen gemäß dem unabhängigen Patentanspruch 10 sowie das Verfahren zum Aufbringen einer Folie auf einem Substrat mit den Merkmalen gemäß dem unabhängigen Patentanspruch 15. Weitere Merkmale und Details der Erfindung ergeben sich aus den Unteransprüchen, der Beschreibung sowie den Zeichnungen. Dabei gelten Merkmale und Details, die im Zusammenhang mit einem der Erfindungsaspekte beschrieben sind, stets vollumfänglich auch im Zusammenhang mit den jeweils anderen beiden Erfindungsaspekten, so dass hinsichtlich der Offenbarung der einzelnen Erfindungsaspekte stets wechselseitig zu den jeweils anderen Erfindungsaspekten vollinhaltlich Bezug genommen und auf die entsprechenden Ausführungen verwiesen wird.

Die vorliegende Erfindung basiert auf dem Grundgedanken, dass eine in besonderer Weise ausgestaltete Aufbringvorrichtung vorgesehen ist, die zumindest eine Federkomponente aufweist, wobei die Federkomponente elastische Rückstellkräfte ausüben kann, durch die die Aufbringvorrichtung während des Aufbringprozesses, bei dem eine Folie auf das Substrat aufgebracht wird, in Bezug auf das Substrat insbesondere automatisch, auf eine optimale Niveauposition eingestellt werden kann.

Die Aufbringvorrichtung hat insbesondere die technische Wirkung, dass mit dieser, insbesondere automatisch, unterschiedliche Substratdicken ausgeglichen werden können.

Gemäß dem ersten Aspekt der Erfindung wird die Aufgabe gelöst durch eine Vorrichtung für das Aufbringen einer Folie auf einem Substrat, aufweisend eine Rahmenkomponente, die derart bereitgestellt ist, dass die Rahmenkomponente in der Lage ist, mit der aufzubringenden Folie zusammenzuwirken, eine Widerlagerkomponente, die derart bereitgestellt ist, dass sie in der Lage ist, ein Widerlager für die Rahmenkomponente zu bilden oder eine Widerlagerfunktion in Bezug auf die Rahmenkomponente auszuüben, sowie eine Federkomponente, die derart bereitgestellt ist, dass sie in der Lage ist, in Bezug auf die Rahmenkomponente eine elastische Rückstellkraft auszuüben.

Gemäß diesem ersten Aspekt der Erfindung wird eine Vorrichtung für das Aufbringen einer Folie auf einem Substrat bereitgestellt.

Dabei kann die Folie grundsätzlich auf verschiedene Weise auf ein Substrat aufgebracht werden. Mit Hilfe der Aufbringvorrichtung soll insbesondere ermöglicht werden, dass das Substrat mit einer Folie überzogen wird, wobei die Folie insbesondere haftend mit dem Substrat verbunden wird. Bevorzugt ist vorgesehen, dass die Aufbringvorrichtung für das Auflaminieren einer Folie auf einem Substrat ausgebildet ist. Beim Laminieren handelt es sich insbesondere um ein stoffschlüssiges Fügeverfahren, mittels dessen die Folie an dem Substrat angeklebt wird.

Grundsätzlich ist die vorliegende Erfindung nicht auf bestimmte Arten von Substraten beschränkt, auf denen eine Folie aufgebracht werden kann. Bei einem Substrat kann es sich generell um eine Unterlage oder Grundlage für die aufzubringende Folie handeln. Bevorzugt handelt es sich bei dem Substrat um einen Wafer, auf dem in einem Wafer-Bearbeitungsprozess eine Folie aufgebracht wird.

Bevorzugt ist deshalb vorgesehen, dass die Aufbringvorrichtung zum Laminieren einer Folie auf einen Wafer verwendet wird oder verwendbar ist, wobei die Erfindung nicht auf diese konkrete Anwendungsform beschränkt ist.

Die erfindungsgemäße Aufbringvorrichtung besteht aus einer Reihe von Komponenten. Die einzelnen Komponenten stellen dabei die einzelnen Bestandteile, Details oder Elemente eines Ganzen, hier der Aufbringvorrichtung, dar. Beispielsweise können die einzelnen Komponenten jeweils ein Einzelteil eines technischen Komplexes darstellen. In diesem Fall ist es auch möglich, dass sich die einzelnen Komponenten der Aufbringvorrichtung allein durch ihre Funktion voneinander unterscheiden. Das bedeutet, dass die Aufbringvorrichtung aus einem einzigen Teil bestehen kann, wobei diesem einzigen Tel aber unterschiedliche Funktionen innewohnen. In anderer Ausgestaltung ist möglich, dass die einzelnen Komponenten Einzelteile einer Baugruppe, hier der Aufbringvorrichtung, darstellen. In diesem Fall handelt es sich bei den Komponenten um verschiedene Bauelemente, die zu einem Ganzen, hier der Aufbringvorrichtung, zusammengefügt beziehungsweise zusammengebaut werden oder sind.

Eine erste Komponente der erfindungsgemäßen Aufbringvorrichtung stellt die Rahmenkomponente dar. Dabei ist die Erfindung grundsätzlich nicht auf bestimmte Ausführungsformen für die Rahmenkomponente beschränkt. Einige bevorzugte Ausführungsformen hierzu werden im weiteren Verlauf der Beschreibung näher erläutert.

Die Rahmenkomponente ist insbesondere in Bezug auf das Substrat zu sehen, auf welchem eine Folie aufgebracht werden soll. Bevorzugt ist vorgesehen, die Rahmenkomponente derart bereitgestellt ist, dass sie in der Lage ist, das Substrat, auf welchem die Folie aufgebracht werden soll, seitlich zu umfassen. Bei der Rahmenkomponente handelt es sich somit bevorzugt um eine seitliche Einfassung des Substrates.

Diese Rahmenkomponente ist derart bereitgestellt ist, dass die Rahmenkomponente in der Lage ist, mit der aufzubringenden Folie zusammenzuwirken. Dabei kann die Rahmenkomponente auf unterschiedliche Weise ausgebildet sein. Einige bevorzugte Ausführungsbeispiele hierzu werden im weiteren Verlauf der Beschreibung näher erläutert.

Die Rahmenkomponente ist derart ausgebildet, dass sie mit der aufzubringenden Folie zusammenwirken kann. Das bedeutet insbesondere, dass die Rahmenkomponente mit der aufzubringenden Folie zusammenkommen, zusammentreffen oder zusammenarbeiten kann. In diesem Fall ist bevorzugt vorgesehen, dass es sich bei der Rahmenkomponente und der aufzubringenden Folie um unterschiedliche Elemente handelt, wobei die Folie unter Verwendung der Aufbringvorrichtung auf dem Substrat aufgebracht wird oder werden kann.

In einem solchen Fall kann die Rahmenkomponente während des Aufbringprozesses der Folie auf dem Substrat mit der Folie ebenfalls in Kontakt kommen. Dazu kann die Rahmenkomponente beispielsweise eine obere Oberfläche aufweisen, die eingerichtet ist, um mit der aufzubringenden Folie in Kontakt zu kommen oder aber eine solche Folie aufzunehmen. In diesem Fall ist die Rahmenkomponente bevorzugt derart ausgebildet, dass die Folie beim Aufbringvorgang sowohl auf dem Substrat als auch auf der Rahmenkomponente aufgebracht wird.

Ein Zusammenwirken zwischen Rahmenkomponente und aufzubringender Folie kann aber auch bedeuten, dass die Rahmenkomponente und die aufzubringende Folie vereint wirken. In diesem Fall kann in anderer Ausgestaltung vorgesehen sein, dass die Rahmenkomponente und die aufzubringende Folie ein einziges Element darstellen, wobei ein Bestanteil des Elements die Funktion der Rahmenkomponente übernimmt. Beispielsweise kann in einem solchen Fall vorgesehen sein, dass eine Folie zum Einsatz kommt, beispielsweise eine Folienbahn, und dass ein Bestanteil der Folie die Funktion der Rahmenkomponente übernimmt, während ein anderer Bestandteil der Folie denjenigen Bestandteil darstellt, der auf dem Substrat aufgebracht wird. Eine etwas andere Ausgestaltung sieht vor, dass die aufzubringende Folie und die Rahmenkomponente zwar voneinander unabhängige Bauelemente darstellen, diese aber, insbesondere vor Beginn eines Aufbringvorgangs, fest miteinander verbunden sind, beispielsweise mittels Kleben, Laminieren, Schweißen oder dergleichen.

Eine weitere Komponente der erfindungsgemäßen Aufbringvorrichtung wird durch die Widerlagerkomponente gebildet. Dabei ist die Erfindung grundsätzlich nicht auf bestimmte Ausführungsformen für die Widerlagerkomponente beschränkt.

Die Widerlagerkomponente hat insbesondere eine Stabilisierungsfunktion, um auftretenden Kräften zur Stabilisierung der Aufbringvorrichtung entgegenzustehen beziehungsweise entgegenzuwirken. Diese Stabilisierungsfunktion nimmt die Widerlagerkomponente insbesondere in Bezug auf die Rahmenkomponente war. Die Widerlagerkomponente ist deshalb derart bereitgestellt, dass sie in der Lage ist, ein Widerlager für die Rahmenkomponente zu bilden oder eine Widerlagerfunktion in Bezug auf die Rahmenkomponente auszuüben.

Im erstgenannten Fall stellt die Widerlagerkomponente bevorzugt ein Bauteil dar, bei dem es sich insbesondere um ein zur Rahmenkomponente eigenständiges Bauteil handelt, welches zumindest zeitweilig mit der Rahmenkomponente zusammenwirkt. In einem solchen Fall kann beispielsweise vorgesehen sein, dass es sich bei der Widerlagerkomponente um ein stabilisierendes Bauteil, beispielsweise eine stabilisierende Fläche, etwa eine stabilisierende Platte, handelt. Im zweiten Fall, wenn die Widerlagerkomponente eine Widerlagerfunktion in Bezug auf die Rahmenkomponente ausübt, kann die Widerlagerkomponente beispielsweise als Bestandteil der Rahmenkomponente, oder aber gar als Bestanteil der aufzubringenden Folie ausgebildet sein. Dieser Bestanteil übt dann den stabilisierenden Effekt aus. In anderer Ausgestaltung kann vorgesehen sein, dass die Widerlagerfunktion durch eine besonders ausgestaltete Widerlagerkomponente ausgeübt wird. Hierbei kann es sich beispielsweise um eine Vorspanneinrichtung handeln, die die Rahmenkomponente unter eine definierte Vorspannung setzt. Einige bevorzugte Ausführungsbeispiele für Widerlagerkomponenten werden im weiteren Verlauf der Beschreibung näher erläutert.

Eine weitere Komponente der erfindungsgemäßen Aufbringvorrichtung wird durch die Federkomponente gebildet. Dabei ist die Erfindung grundsätzlich nicht auf bestimmte Ausführungsformen für die Federkomponente beschränkt. Einige bevorzugte Ausführungsformen hierzu werden im weiteren Verlauf der Beschreibung näher erläutert.

Bevorzugt ist die Federkomponente derart bereitgestellt, dass sie in der Lage ist, in Bezug auf die Rahmenkomponente eine elastische Rückstellkraft auszuüben. Die Federkomponente ist somit in einer Weise ausgebildet, dass sie unter Belastung nachgeben und nach Entlastung in die ursprüngliche Gestalt zurückkehren kann.

Beispielsweise kann es sich bei der Federkomponente bevorzugt um ein Bauteil handeln, bei dem es sich insbesondere um ein zur Rahmenkomponente und zur Widerlagerkomponente eigenständiges Bauteil handelt, welches zumindest zeitweilig mit der Rahmenkomponente und/oder der Widerlagerkomponente zusammenwirkt.

Die Federkomponente kann in Bezug auf die Rahmenkomponente eine elastische Rückstellkraft ausüben. In einem solchen Fall kann die Federkomponente beispielsweise als Bestandteil der Rahmenkomponente, oder der Widerlagerkomponente, oder aber gar als Bestanteil der aufzubringenden Folie ausgebildet sein. Dieser Bestanteil übt dann die elastischen Rückstellkräfte aus. Bevorzugt ist vorgesehen, dass die Rahmenkomponente über die Federkomponente federnd mit der Widerlagerkomponente in Verbindung steht, insbesondere, dass die Rahmenkomponente über die Federkomponente federnd auf/an der Widerlagerkomponente gelagert ist, so dass sich die Rahmenkomponente und die Widerlagerkomponente federnd gegeneinander abstützen.

Die grundlegende Funktionsweise der drei Komponenten der erfindungsgemäßen Aufbringvorrichtung sowie deren Zusammenwirken wird nun anhand eines allgemeinen Ausführungsbeispiels verdeutlicht.

Wenn eine Folie auf ein Substrat aufgebracht werden soll, ist möglicherweise die genaue Dicke des Substrats nicht bekannt, da die Dicken der zu behandelnden Substrate variieren können. Es ist deshalb erforderlich, solche unterschiedlichen Dicken ausgleichen zu können. Dies geschieht mit Hilfe der erfindungsgemäßen Aufbringvorrichtung. Wie im weiteren Verlauf der Beschreibung noch näher erläutert wird, wird das Substrat, welches mit einer Folie versehen werden soll, bevorzugt seitlich von der Aufbringvorrichtung eingefasst. Wird nun die Folie auf das Substrat aufgebracht, was beispielsweise unter Verwendung einer an sich bereits bekannten Druckrolle geschehen kann, so wird die Folie ebenfalls auf die Rahmenkomponente aufgebracht, die das Substrat einfasst. Damit übt diese Druckrolle auch eine Druckkraft auf die Rahmenkomponente aus. Die Rahmenkomponente wird dabei nach unten gedrückt, wodurch der Druck auch auf die Federkomponente weitergegeben wird. Dadurch verändert die Federkomponente ihre Form und es entsteht eine elastische Rückstellkraft. Bei Wegfall der Druckkraft wird die Federkomponente anschließend in ihre Ursprungsform zurückkehren. Damit dieser Effekt erzielt werden kann, ist zusätzlich die stabilisierende Widerlagerkomponente erforderlich, die die gesamte Aufbringvorrichtung stabilisiert.

Durch die erfindungsgemäße Ausgestaltung der Aufbringvorrichtung ist es deshalb möglich, dass die Rahmenkomponente während des Aufbringvorgangs der Folie auf das Substrat, beispielsweise mittels einer Druckrolle einer Bearbeitungsvorrichtung, ohne darüber hinausgehende Hilfsmittel und insbesondere ohne einen eigenen Antrieb auf das Niveau des Substrats gebracht wird, indem die Federkomponente einfach in dem erforderlichen Maß zusammengedrückt wird. Nach Beendigung des Aufbringprozesses kehrt die Rahmenkomponente aufgrund der elastischen Rückstellkräfte automatisch in die Ausgangsposition zurück.

Bevorzugt ist vorgesehen, dass das Niveau der Rahmenkomponente, insbesondere das Niveau einer oberen Oberfläche der Rahmenkomponente, im Ausgangszustand oberhalb des Niveaus, insbesondere des Niveaus einer oberen Oberfläche, des mit der Folie zu versehenden Substrats liegt. Je größer der Niveauunterschied ist, das heißt je höher das Niveau der Rahmenkomponente im Vergleich zum Niveau des Substrats liegt, desto größere Unterschiede in den Substratdicken können mit der Aufbringvorrichtung ausgeglichen werden.

Im Folgenden werden verschiedene bevorzugte Ausführungsformen beschrieben, wie die Aufbringvorrichtung für das Aufbringen einer Folie ausgebildet sein kann.

Werden die einzelnen Komponenten der Aufbringvorrichtung rein funktional ausgebildet, kann vorgesehen sein, dass die Aufbringvorrichtung als ein einziges Bauteil ausgebildet ist, wobei dann die einzelnen Bestandteile der Aufbringvorrichtung die Funktion einer Rahmenkomponente, einer Widerlagekomponente und einer Federkomponente übernehmen. In einer besonderen Ausführungsform könnte eine solche Aufbringvorrichtung in Form einer besonders ausgestalteten Folie ausgebildet sein. Dabei ist nicht ausgeschlossen, dass es sich bei dieser Folie sogar um die auf dem Substrat aufzubringende Folie selbst handelt.

In anderer Ausgestaltung ist bevorzugt vorgesehen, dass es sich zumindest bei der Rahmenkomponente und der Widerlagerkomponente um in Bezug zueinander eigenständige Bauteile handelt. Dabei ist bevorzugt vorgesehen, dass die Rahmenkomponente und die Widerlagerkomponente lösbar miteinander verbunden sind oder aufeinander angeordnet sind, wobei die Rahmenkomponente in einem solchen Fall lösbar an/auf der Widerlagerkomponente angeordnet sein kann. Bevorzugte Ausführungsbeispiele hierzu werden im weiteren Verlauf der Beschreibung näher erläutert.

In ähnlicher Weise kann auch die Federkomponente als eigenständiges Bauteil ausgebildet sein. In anderer Ausgestaltung ist denkbar, dass die Federkomponente ein Bestandteil der Rahmenkomponente und/oder der Widerlagerkomponente ist.

Bevorzugt ist die Federkomponente zwischen der Rahmenkomponente und der Widerlagerkomponente angeordnet oder ausgebildet. Durch eine auf die Rahmenkomponente ausgeübte Kraft, die sich auf die Federkomponente überträgt, wird in der Federkomponente eine elastische Rückstellkraft erzeugt, da sich die Federkomponente auf der stabilisierenden Widerlagerkomponente abstützt.

In einer besonderen Ausführungsform kann beispielsweise vorgesehen sein, dass die Aufbringvorrichtung einen schichtförmigen Aufbau hat. Dabei kann eine erste Schicht in Form einer unteren Schicht durch die Widerlagerkomponente gebildet werden. Eine zweite Schicht in Form einer oberen Schicht kann durch die Rahmenkomponente gebildet werden. Eine dritte, dazwischen liegende Schicht kann durch die Federkomponente gebildet werden. Dabei kann vorgesehen sein, dass die Schichten lösbar mit einander verbunden sind. Dies gilt insbesondere für die Rahmenkomponente und die Widerlagerkomponente. Die Federkomponente kann entweder auch lösbar vorgesehen sein oder aber mit einer der beiden anderen Komponenten fest verbunden sein. In anderer Ausgestaltung ist möglich, dass die einzelnen Komponenten unlösbar miteinander verbunden sind. Beispielsweise kann die Aufbringvorrichtung in Form einer aus drei Schichten bestehenden Folie ausgebildet sein. Wenn die Aufbringvorrichtung schichtförmig ausgebildet ist, kann diese beispielsweise vorab mit der aufzubringenden Folie verbunden werden, was insbesondere durch eine entsprechende Verbindung zwischen Rahmenkomponente und aufzubringender Folie in der wie weiter oben beschriebenen Weise erfolgen kann.

Bevorzugt kann die Rahmenkomponente als Rahmenelement ausgebildet sein. Bei einem solchen Rahmenelement handelt es sich insbesondere um ein Gerüstelement, welches das zu behandelnde Substrat und gegebenenfalls die Halteeinrichtung, auf der sich das zu behandelnde Substrat befindet, seitlich einfasst. Das bedeutet, dass das Substrat während des Anbringens der Folie bevorzugt an allen Seiten von dem Rahmenelement umgeben ist. Beispielsweise kann das Rahmenelement als Rahmenplatte oder Rahmenfläche ausgebildet sein.

Alternativ oder zusätzlich kann die Widerlagerkomponente als Widerlagerelement ausgebildet sein. Bei dem Widerlagerelement kann es sich beispielsweise ebenfalls um eine Art Gerüstelement handeln, welches das zu behandelnde Substrat und gegebenenfalls die Halteeinrichtung, auf der sich das zu behandelnde Substrat befindet, seitlich einfasst. In einem solchen Fall kann das Widerlagerelement beispielsweise als Widerlagerplatte oder Widerlagerfläche ausgebildet sein. In anderer Ausgestaltung kann das Widerlagerelement als eine Vorspanneinrichtung ausgebildet sein. Über eine solche Vorspanneinrichtung wird während des Aufbringprozesses der Folie auf dem Substrat eine mechanische Spannung erzeugt, die dann das gewünschte Verhalten, hier den stabilisierenden Effekt, erreicht. Alternativ oder zusätzlich kann die Federkomponente als wenigstens ein Federelement ausgebildet sein. Je nach Ausgestaltung des Federelements ist es in einer einfachen Ausführungsform möglich, dass nur ein einzelnes Federelement zum Einsatz kommt. In anderer Ausgestaltung können aber auch zwei oder mehr Federelemente zum Einsatz kommen.

Im Hinblick auf die vorgenannten Ausgestaltungsmöglichkeiten der einzelnen Komponenten der Aufbringvorrichtung werden nachfolgend einige bevorzugte Ausführungsformen beschrieben.

Gemäß einer ersten bevorzugten Ausführungsform kann es sich bei der Rahmenkomponente und bei der Widerlagerkomponente jeweils um eine Platte handeln. Die Rahmenplatte und die Widerlagerplatte sind bevorzugt lösbar miteinander verbunden oder aufeinander angeordnet. Zwischen den Platten ist dann die Federkomponente in Form wenigstens eines Federelements vorgesehen. Wenn auf die Rahmenplatte während des Aufbringvorgangs der Folie ein Druck ausgeübt wird, was beispielswiese durch eine Druckrolle geschehen kann, die sich über die Rahmenkomponente und das darin eingefasste Substrat hinwegbewegt, wird die Druckkraft auf das wenigstens eine Federelement übertragen, welches sich gegen die stabilisierende Widerlagerplatte abstützt, so dass in dem wenigstens einen Federelement eine elastische Rückstellkraft entsteht.

Gemäß einer anderen bevorzugten Ausführungsform kann beispielsweise vorgesehen sein, dass die auf dem Substrat aufzubringende Folie in einem ersten Schritt zunächst mit einer Aufbringvorrichtung verbunden wird. Bei der Aufbringvorrichtung kann es sich dann beispielsweise um eine Folie handeln, die die drei Komponenten der Aufbringvorrichtung in sich vereint. Entweder kann die Folie hierzu unterschiedliche Bereiche aufweisen, oder aber die Folie ist aus mehreren Lagen beziehungsweise Schichten unterschiedlicher Folien zusammengesetzt. Insbesondere kann es sich bei der Aufbringvorrichtung in einem solchen Fall um ein im Vergleich zur aufzubringenden Folie festeres oder stabileres Material handeln. In einem ersten Schritt könnte die aufzubringende Folie, beispielsweise in einem Laminierschritt oder dergleichen, an der die Aufbringvorrichtung darstellenden Folie befestigt werden.

In einem solchen Fall kann die Aufbringvorrichtung bevorzugt mehrere hintereinander angeordnete oder ausgebildete Rahmenkomponenten mit dazugehörigen Widerlagerkomponenten und Federkomponenten aufweisen. Dieses Material könnte dann später in Form von Folienrollen oder Folienbahnen für das Aufbringen von Folien auf das Substrat verwendet werden.

In einem solchen Fall kommt bevorzugt eine wie weiter oben beschriebene Vorspanneinrichtung zum Einsatz. Die Federfunktion und die Widerlagerfunktion werden dann durch die Vorspannung der Folie und insbesondere durch die entstehenden Haltemomente, die beispielsweise durch geeignete Halterollen der Vorspanneinrichtung erzeugt werden, erzeugt.

In anderer Ausgestaltung kann eine Aufbringvorrichtung mehrere hintereinander angeordnete oder ausgebildete Rahmenkomponenten mit dazugehörigen Widerlagerkomponenten und Federkomponenten aufweisen, die eine geschlossene Bahn bilden, so dass eine entsprechende Aufbringvorrichtung im Umlaufverfahren betrieben werden könnte.

Bevorzugt ist vorgesehen, dass die Federkomponente an der Rahmenkomponente angeordnet oder darin/daran ausgebildet ist, und/oder dass die Federkomponente an Widerlagerkomponente angeordnet oder darin/daran ausgebildet ist, und/oder dass die Federkomponente ein eigeständiges Bauteil ist, das zwischen der Rahmenkomponente und der Widerlagerkomponente angeordnet ist. Dabei ist die Erfindung nicht auf bestimmte Ausführungsformen für die Federkomponenten beschränkt.

Bevorzugt ist die Federkomponente als wenigstens ein wie weiter oben schon näher beschriebenes Federelement zum Erzeugen elastischer Rückstellkräfte ausgebildet. Beispielsweise kann ein solches Federelement als elastisches Element, beispielsweise als ein Gummielement oder Kautschukelement oder generell als Elastomerelement ausgebildet sin. Ein Elastomerelement ist ein formfestes, aber elastisch verformbares Kunststoffelement. Alternativ oder zusätzlich kann ein solches Federelement als ein federndes Druckstück ausgebildet sein. Bei derartigen Druckstücken handelt es sich um dem Fachmann an sich bekannte Normteile für Maschinen und Anlagen. Alternativ oder zusätzlich kann ein solches Federelement beispielswiese auch als Luftspalt ausgebildet sein. Hierbei ist bevorzugt vorgesehen, dass der Luftspalt nach allen Seiten abgeschlossen ist, so dass die elastische Rückstellkraft erzeugt wird, wenn die im Luftspalt befindliche Luft komprimiert wird.

Je nach Ausgestaltung können eine oder mehrere Federelemente, auch Federelemente unterschiedlicher Ausgestaltung, zum Einsatz kommen. Wichtig ist in jedem Fall, dass eine möglichst gleichmäßige elastische Rückstellkraft erzeugt wird. Dies kann möglicherweise bereit mit einem einzigen Federelement erreicht werden. Bevorzugt können jedoch mehr als ein Federelement vorgesehen sein. Dabei sind die Federelemente bevorzugt im Randbereich zwischen dem Rahmenelement und dem Widerlagerelement vorgesehen. Je mehr Federelemente vorhanden sind, desto geringer ist die Gefahr, dass sich das Rahmenelement, wenn auf dieses eine Kraft ausgeübt wird, wodurch das Rahmenelement in Richtung des Widerlagerelements gedrückt wird, durchbiegt oder verkantet. In einer bevorzugten Ausführungsform können vier oder mehr, bevorzugt acht oder mehr, besonders bevorzugt zwölf oder mehr Federelemente zum Einsatz kommen, die dann bevorzugt im Randbereich zwischen Rahmenelement und Widerlagerelement angeordnet beziehungsweise vorgesehen oder ausgebildet sind.

In weiterer Ausgestaltung kann die Rahmenkomponente, insbesondere wenn diese als Rahmenelement, etwa als Rahmenplatte, ausgebildet ist, eine oder mehrere Aussparungen aufweisen. Bei einer solchen Aussparung handelt es sich insbesondere um eine ausgesparte Fläche in der Rahmenkomponente. Hinsichtlich der Anzahl, Größe und Form ist die Erfindung nicht auf bestimmte Ausführungen solcher Aussparungen beschränkt. Die Aussparungen sind bevorzugt so gewählt, dass die Rahmenkomponente an sich noch stabil und insbesondere möglichst verwindungssteif ist. Beispielsweis kann vorgesehen sein, dass die Aussparungen dreieckförmig oder annährend dreieckförmig ausgebildet sind. Bevorzugt befinden sich die Aussparungen in den Ecken der Rahmenkomponente. Bevorzugt sind vier solcher Aussparungen vorgesehen, wobei in jeder Ecke eine solche Aussparung vorgesehen ist. Die Aussparungen dienen insbesondere dem Zweck, die Masse und damit das Gewicht der Rahmenkomponente zu verringern. Denn im Rahmen eines Bearbeitungsprozesses, der weiter unten noch näher erläutert wird, kann vorgesehen sein, dass die Rahmenkomponente von der Widerlagerkomponente abgehoben wird. Je geringer dabei das Gewicht der Rahmenkomponente ist, desto weniger Kraft muss aufgebracht werden, um das Rahmenelement anzuheben.

In weiterer Ausgestaltung weist die Widerlagerkomponente bevorzugt wenigstens ein Fixierelement zum Fixieren der Rahmenkomponente auf. Solche Fixierelemente, die beispielsweise als Fixierbolzen, Fixierstifte oder dergleichen ausgebildet sein können, sind insbesondere dann von Vorteil, wenn die Rahmenkomponente lösbar mit der Widerlagerkomponente verbunden ist, beispielsweise dann, wenn die Rahmenkomponente über die Federkomponente lösbar auf der Widerlagerkomponente aufliegt. Durch das wenigstens eine Fixierelement wird die Rahmenkomponente in eine definierte Position gebracht und in dieser gehalten. Beispielsweise können die Fixierelemente dazu mit den weiter oben beschriebenen Aussparungen zusammenwirken und in diese eingreifen. Wenn es sich bei der Rahmenkomponente und der Widerlagerkomponente um insbesondere viereckige Elemente handelt, befinden sich die Fixierelemente bevorzugt in den Ecken.

Bevorzugt weist die Rahmenkomponente wenigstens eine Befestigungseinrichtung zum Befestigen der Rahmenkomponente an einer Halteeinrichtung auf. Damit wird es möglich, die Rahmenkomponente von der Aufbringvorrichtung abzuheben. Dies kann in verschiedenen Bearbeitungsschritten von Vorteil sein.

Beispielsweise kann vorgesehen sein, dass die Aufbringvorrichtung Bestandteil einer unteren Haltevorrichtung ist. Das Substrat wird auf der unteren Haltevorrichtung gehalten, während die Folie auf das Substrat aufgebracht wird. Wenn die Rahmenkomponente das Substrat dabei umgibt und seitlich einfasst, wird die Folie bevorzugt auch auf der Rahmenkomponente aufgebracht. Das Substrat ist somit über die Folie an der Rahmenkomponente befestigt. Für einen weiteren Bearbeitungsschritt kann es nun vorteilhaft sein, wenn die neu gebildete Einheit "Rahmenkomponente, Substrat mit darüber liegender Folie" einer anderen Haltevorrichtung zugeführt wird, die beispielsweise oberhalb der unteren Haltevorrichtung vorgesehen ist und insoweit eine obere Haltevorrichtung bildet. Über die wenigstens eine Befestigungseinrichtung kann die Rahmenkomponente dann mit der oberen Halteeinrichtung in Verbindung gebracht werden. Ein solches Ausführungsbeispiel wird im weiteren Verlauf der Beschreibung noch näher erläutert.

Grundsätzlich ist die Erfindung nicht auf bestimmte Ausführungsformen für die Befestigungseinrichtung beschränkt. Beispielsweis kann es sich hierbei um entsprechende Klemmelemente wie Klemmleisten, Klemmgreifer, Klemmklauen, Rastelemente und dergleichen handeln, oder aber um Aufnahmeelemente, Aufnahmebereiche oder dergleichen, die mit den vorgenannten Klemmelementen zusammenwirken.

Bevorzugt weist die Rahmenkomponente und/oder die Widerlagerkomponente wenigstens eine Öffnung auf, die derart bereitgestellt ist, dass sie in der Lage ist, eine Halteeinrichtung mit einem darauf befindlichen Substrat, auf dem die Folie aufgebracht werden soll, zu umgeben. Auf diese Weise wird erreicht, dass das Substrat, auf dem eine Folie aufgebracht werden soll und gegebenenfalls die Halteeinrichtung, auf der sich das Substrat befindet, seitlich von der Rahmenkomponente und/der der Widerlagerkomponente, eingefasst ist/sind. Die vorliegende Erfindung ist nicht auf bestimmte Größen der Öffnungen beschränkt. Diese ergeben sich vielmehr aus dem Anwendungsgebiet. In jedem Fall müssen die Öffnungen größer sein als die Durchmesser des Substrats und gegebenenfalls der Halteeinrichtung, da diese ja innerhalb der Öffnungen liegen.

In einer bevorzugten Ausführungsform weisen die Rahmenkomponente und die Widerlagerkomponente eine viereckige Form auf. Bevorzugt hat das Rahmenelement eine Kantenlänge von jeweils 510 mm und eine Dicke von 5 mm. Der Durchmesser der wie vorstehend beschriebenen Öffnung beträgt bevorzugt 492 mm.

Gemäß einem zweiten Aspekt der Erfindung wird eine Bearbeitungsvorrichtung zum Bearbeiten eines Substrats bereitgestellt. Die Bearbeitungsvorrichtung dient insbesondere dazu, ein Substrat zu behandeln oder zu bearbeiten. Die Bearbeitungseinrichtung weist einen Bearbeitungstisch auf, auf dem das Substrat behandelt oder bearbeitet wird. Hierzu weist der Bearbeitungstisch eine Halteeinrichtung zur Aufnahme eines Substrats auf. Während der Behandlung oder Bearbeitung des Substrats befindet sich das Substrat auf der Halteeinrichtung.

Handelt es sich bei dem Substrat um einen Wafer, so handelt es sich bei der Halteeinrichtung bevorzugt um einen so genannten Chuck. Ein Chuck stellt insbesondere eine Halterung dar, die beispielsweise an dem Bearbeitungstisch montiert ist. Der Chuck nimmt den Wafer beispielsweise mittels eines erzeugten Vakuums auf.

Weiterhin weist die Bearbeitungseinrichtung eine wie vorstehend beschriebene erfindungsgemäße Aufbringvorrichtung zum Aufbringen einer Folie auf das Substrat auf, so dass diesbezüglich vollinhaltlich auf die vorstehenden Ausführungen zu der erfindungsgemäßen Aufbringvorrichtung Bezug genommen und verwiesen wird.

Bevorzugt ist vorgesehen, dass um die Halteeinrichtung und/oder das Substrat herum die erfindungsgemäße Aufbringvorrichtung angeordnet ist. Damit eine Folie auf das Substrat aufgebracht werden kann, wird das Substrat zunächst auf der Halteeinrichtung angeordnet. Die Aufbringvorrichtung wird so angeordnet, dass das Substrat von allen Seiten eingefasst ist. Hierzu weist zumindest die Rahmenkomponente und optional auch die Widerlagerkomponente eine entsprechende Öffnung auf, die so bemessen ist, dass sie größer ist als der Durchmesser des zu bearbeitenden Substrats beziehungsweise der Halteeinrichtung, auf der sich das Substrat befindet.

Soll nun eine Folie auf das Substrat aufgebracht werden, so wird die aufzubringende Folie über dem Substrat und wegen der Anordnung der Rahmenkomponente auch oberhalb der Rahmenkomponente platziert.

Bevorzugt weist die Bearbeitungseinrichtung eine Folienzufuhr zum insbesondere kontinuierlichen Zuführen einer aufzubringenden Folie auf.

Während des Aufbringprozesses wird die Folie bevorzugt auf dem Substrat und auf der Rahmenkomponente angedrückt. Hierzu weist die Bearbeitungsvorrichtung bevorzugt wenigstens eine Druckrolle zum Übertragen einer Druckkraft auf die aufzubringende Folie auf.

Durch die Federkomponente in der Aufbringvorrichtung wird beim Ausüben der Druckkraft auf die Rahmenkomponente diese nach unten gedrückt, und zwar so weit, bis das Niveau des Substrats mit dem Niveau der Rahmenkomponente genau übereinstimmt. Dabei ist es für den Aufbringprozess nicht erforderlich, das Niveau, das heißt die Höhe des Substrats zu kennen. Denn die Rahmenkomponente kann durch die Druckkraft, die beispielsweise über eine Druckrolle erzeugt wird, so weit wie nötig nach unten gedrückt werden. Die obere Oberfläche des Substrats und die obere Oberfläche der Rahmenkomponente liegen nun in einer Ebene, so dass die Folie einfach, sowie faltenfrei und blasenfrei auf dem Substrat aufgebracht werden kann. Dach Beendigung des Aufbringprozesses ist das Substrat über die angebrachte Folie insbesondere auch mit dem Rahmenelement verbunden, an dem die Folie ebenfalls angebracht ist.

In weiterer Ausgestaltung kann die Bearbeitungsvorrichtung wenigstens eine Einrichtung zum Folien-Querstrecken aufweisen. Bevorzugt können zwei solcher Einrichtungen vorgesehen sein. Die Einrichtung zum Folien-Querstrecken zeichnet sich insbesondere dadurch aus, dass diese wenigstens eine Rotationsdämpfereinrichtung aufweist. Nachfolgend wird die Einrichtung zum Folien-Querstrecken in größerem Detail beschrieben.

Die Bearbeitungsvorrichtung muss beispielsweise 500 mm breite Folie handhaben, welche am Ende des Bearbeitungsprozesses ausgeschnittene Löcher mit 400 mm Durchmesser aufweisen kann. Nachdem die Folie in der wie vorstehend beschriebenen Weise auf dem Substrat und auch der Rahmenkomponente angeordnet worden ist, kann diese Einheit "Rahmenkomponente, Substrat, Folie" einem weiteren Bearbeitungsprozess zugeführt werden. Am Ende dieses Bearbeitungsprozesses kann vorgesehen sein, dass das Substrat aus der Rahmenkomponente ausgeschnitten wird. Zurück bleibt dann die Folie mit den vorgenannten ausgeschnittenen Löchern, die zusätzlich auch von der Rahmenkomponente abgelöst wird. Insbesondere wenn die aufgebrachte Folie kontinuierlich über eine Folienrolle abgewickelt wird, müssen die nicht mehr benötigten Folienteile mit den ausgeschnittenen Löchern weiter transportiert werden. Wenn an einer Folie mit einem so großen Loch gezogen wird, engt sie sich noch stärker ein als es schon ohne Loch der Fall ist.

Um diesem Effekt entgegenzuwirken, wird die Folie mit Hilfe von Breitstreckwalzen und Querstreckern auf möglichst voller Breite gehalten. Dies ist notwendig, damit die Folie faltenfrei auf den Wafer laminiert werden kann und dass der Folienrest sauber mit möglichst wenig Falten auf eine Zielrolle aufgewickelt werden kann.

Mit Hilfe der Einrichtung zum Folien-Querstrecken kann die Folie, auch während sie stillsteht, auch mit den Querstreckern quergestreckt und in dem gedehnten Zustand wieder geklemmt werden.

Die Querstrecker klemmen die Folie zwischen Backen und ziehen diese quer zur Bewegungsrichtung. Damit sich die Folie nicht durch die Zwangsführung in den Backen plastisch überdehnt, kann die Kraft der Querstrecker mittels Druckbegrenzung, beispielsweise von Pneumatikzylindern erreicht werde. Die obere Klemme des Querstreckers ist insbesondere antihaftbeschichtet, die Folie lässt sich auf ihr recht reibungsfrei verschieben. Die untere Klemme, welche die Klebende Seite der Folie berührt, ist bevorzugt ein Synchronriemen, welcher über Riemenscheiben umgelenkt wird. Die Riemenscheiben sind weder fixiert noch frei drehend, sondern auf Rotationsdämpfern montiert. Durch diese Elemente kann sich der Riemen bei der Querstreckbewegung nur so leicht und nur so weit verschieben, bis eine Querspannung der Folie erreicht wird, die den elastischen Bereich noch nicht überschreitet.

Die Klemmbewegung wird über die untere Klemmbacke, beispielsweise mittels Pneumatikzylinder, ausgeführt. Über den Luftdruck kann man die Klemmkraft steuern. Die Querbewegung wird ebenso über die untere Klemmbacke mittels Pneumatikzylinder ausgeführt. Die oberen Klemmbacken werden auf Linearführungen in Querrichtung geführt und in den anderen Achsrichtungen fixiert. Die Rückstellbewegung nach innen übernimmt bevorzugt eine Zugfeder.

Zur Unterstützung der Querstreckfunktion ist in weiterer Ausgestaltung vorgesehen, dass die Bearbeitungsvorrichtung wenigstens eine Sensoreinrichtung zur Messung der Folienbreite aufweist. Hierzu kann beispielsweise ein Gabelsensor, beispielsweise ein Ultraschall-Kantensensor, zum Einsatz kommen, der Kanten von schallundurchlässigen Materialien wie Folien oder dergleichen abtasten kann. Derartige Sensorelemente an sich sind dem Fachmann geläufig. In der Gabel sitzt in einem der Schenkel ein Ultraschallsender, der kurze Schallimpulse aussendet. Diese werden von einem Ultraschallempfänger, der in dem anderen Gabelschenkel sitzt, detektiert. Eine in die Gabel eintauchende Folie deckt die Schallstrecke ab und dämpft damit das Empfangssignal, Dies wird in der Sensorelektronik ausgewertet.

Gemäß noch einem weiteren Aspekt der Erfindung wird Verfahren zum Aufbringen einer Folie auf ein Substrat bereitgestellt, dass unter Verwendung einer wie vorstehend beschriebenen erfindungsgemäßen Bearbeitungsvorrichtung durchgeführt wird. Aus diesem Grund wird bezüglich der Funktionsweise des Verfahrens auch auf die vorstehenden Ausführungen zu den zuvor beschriebenen Erfindungsaspekten vollinhaltlich Bezug genommen und verwiesen. Das Verfahren ist gekennzeichnet durch folgende Schritte:

Ein Substrat wird auf der Halteeinrichtung des Bearbeitungstisches aufgebracht, wobei die Halteeinrichtung mit dem darauf befindlichem Substrat von der Aufbringvorrichtung umgeben ist oder wird. Eine Folie wird auf die Rahmenkomponente der Aufbringvorrichtung und auf das Substrat aufgebracht. Es wird eine Druckkraft, beispielsweise über eine Druckrolle, auf die Rahmenkomponente und das Substrat übertragen, um die Folie an das Substrat und die Rahmenkomponente anzudrücken. Durch die übertragene Druckkraft wird die Rahmenkomponente nach unten gedrückt, wobei in der Federkomponente der Aufbringvorrichtung eine elastische Rückstellkraft erzeugt und auf die Rahmenkomponente der Aufbringvorrichtung ausgeübt wird. Dadurch wird erreicht, dass sich das Niveau der Rahmenkomponente und das Niveau des Substrats, unabhängig von der Dicke des Substrats, stets in derselben Ebene befinden, so dass die Folie faltenfrei auf dem Substrat, und optional auch auf der Rahmenkomponente, aufgebracht werden kann.

Die Erfindung wird nun anhand von Ausführungsbeispielen unter Bezugnahme auf die beiliegenden Zeichnungen näher erläutert. Es zeigen
- Figur 1: die schematische Ansicht einer erfindungsgemäßen Aufbringvorrichtung;
- Figur 2: die schematische Ansicht einer Rahmenkomponente der erfindungsgemäßen Aufbringvorrichtung;
- Figur 3: die schematische Ansicht einer Widerlagerkomponente der erfindungsgemäßen Aufbringvorrichtung;
- Figur 4: die schematische Ansicht einer Federkomponente der erfindungsgemäßen Aufbringvorrichtung;
- Figur 5: die schematische Ansicht einer anderen Ausführungsform der erfindungsgemäßen Aufbringvorrichtung;
- Figur 6: die schematische Ansicht einer Bearbeitungsvorrichtung gemäß der vorliegenden Erfindung;
- Figuren 7 bis 9: den Aufbringvorgang einer Folie auf einen Substrat und die Rahmenkomponente;
- Figur 10: einen weiteren Bearbeitungsschritt nach erfolgtem Aufbringen der Folie auf das Substrat und die Rahmenkomponente;
- Figur 11: eine Frontansicht einer in der Bearbeitungsvorrichtung verwendeten Einrichtung zum Folien-Querstrecken; und
- Figur 12: eine perspektivische Ansicht der in Figur 10 dargestellten Einrichtung zum Folien Querstrecken.

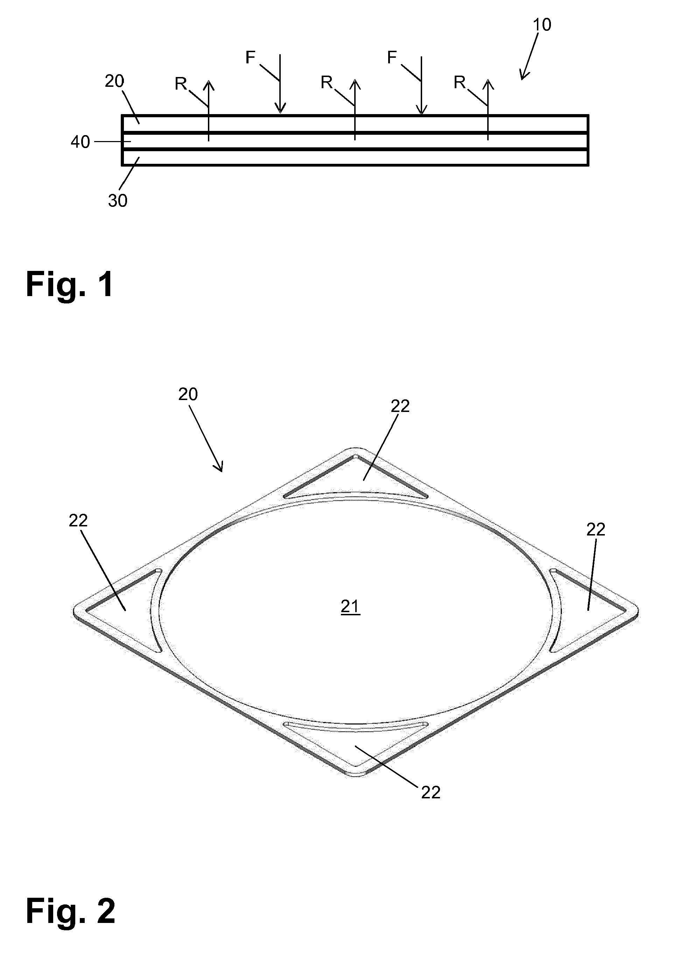

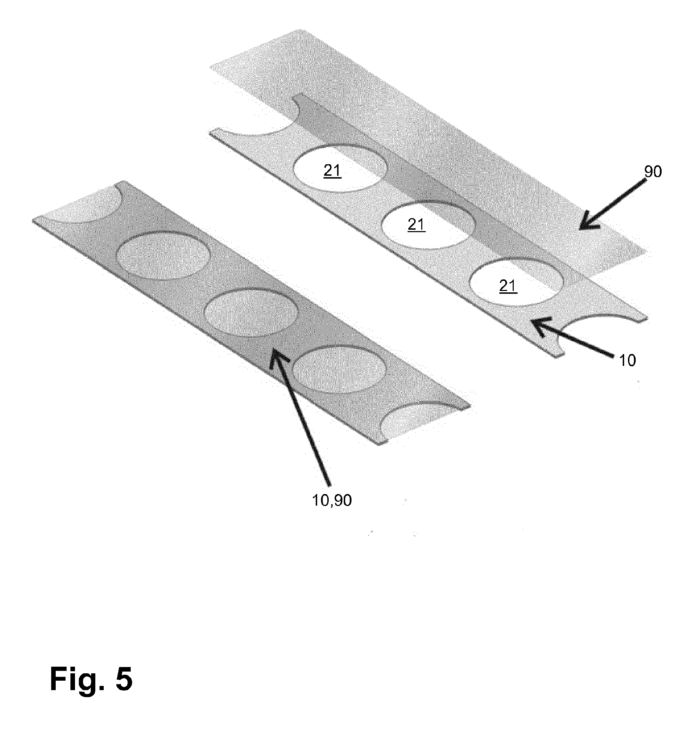

In Figur 1 ist schematisch eine Vorrichtung 10 zum Aufbringen einer Folie auf einem Substrat dargestellt, die aus einer Reihe von Komponenten zusammengesetzt ist. Die Aufbringvorrichtung 10 ist Bestandteil einer Bearbeitungsvorrichtung, die zum Bearbeiten von Substraten in Form von Wafern verwendet wird, und die in Figur 5 in größerem Detail dargestellt ist.

Die in Figur 1 dargestellte Aufbringvorrichtung 10 besteht zunächst aus einer Rahmenkomponente 20, die in Form einer Rahmenplatte ausgebildet ist. Die Rahmenkomponente 20 ist insbesondere in Bezug auf ein Substrat zu sehen, auf welchem eine Folie aufgebracht werden soll. Die Rahmenkomponente 20 ist derart bereitgestellt, dass sie in der Lage ist, das Substrat, auf welchem die Folie aufgebracht werden soll, seitlich zu umfassen. Weiterhin verfügt die Aufbringvorrichtung 10 über eine Widerlagerkomponente 30, die in Form einer Widerlagerplatte ausgebildet ist. Die Widerlagerkomponente 30 hat eine Stabilisierungsfunktion, um auftretenden Kräften zum Zwecke der Stabilisierung der Aufbringvorrichtung 10 entgegenzuwirken. Diese Stabilisierungsfunktion nimmt die Widerlagerkomponente 30 insbesondere in Bezug auf die Rahmenkomponente 20 war. Die Widerlagerkomponente 30 ist deshalb derart bereitgestellt, dass sie in der Lage ist, ein Widerlager für die Rahmenkomponente 20 zu bilden oder eine Widerlagerfunktion in Bezug auf die Rahmenkomponente 20 auszuüben. Schließlich verfügt die Aufbringvorrichtung 10 noch über eine Federkomponente 40, wobei die Rahmenkomponente 20 über die Federkomponente 40 federnd mit der Widerlagerkomponente 30 in Verbindung steht, so dass sich die Rahmenkomponente 20 und die Widerlagerkomponente 30 federnd gegeneinander abstützen. Die Federkomponente 30 ist zwischen der Rahmenkomponente 20 und der Widerlagerkomponente 30 angeordnet.

In Figur 2 ist ein Ausführungsbeispiel einer Rahmenkomponente 20 in größerem Detail dargestellt. Die als Rahmenplatte ausgebildete Rahmenkomponente 20 weist einen viereckigen Aufbau auf. Die Rahmenkomponente 20 hat eine Kantenlänge von jeweils 510 mm und eine Dicke von 5 mm. In der Rahmenkomponente 20 ist eine Öffnung 21 vorgesehen, die dazu dient, das Substrat, auf dem die Folie aufgebracht werden soll und gegebenenfalls auch eine Halteinrichtung, auf der das Substrat angeordnet ist, allseitig zu umgeben, so dass das Substrat seitlich von der Rahmenkomponente 20 eingefasst ist. Der Durchmesser der wie vorstehend beschriebenen Öffnung 21 beträgt bevorzugt 492 mm. Um eine Gewichtsreduktion zu erreichen, weist die Rahmenkomponente 20 in den vier Eckbereichen jeweils eine Aussparung 22 auf, die eine an ein Dreieck angenäherte Kontur hat. Die Rahmenkomponente 20 weist somit eine Gerüststruktur auf, die nur ein geringes Materialgewicht hat, die aber dennoch ausreichend stabil ist.

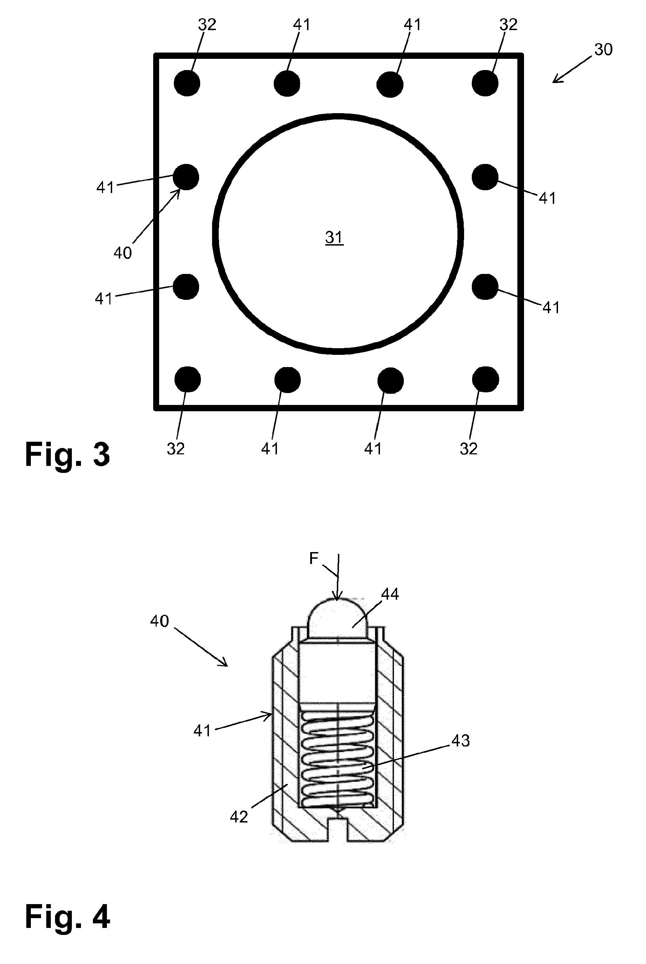

In Figur 3 ist ein Ausführungsbeispiel einer Widerlagerkomponente 30 in größerem Detail beschrieben. Die als Widerlagerplatte ausgebildete Widerlagerkomponente 30 weist einen viereckigen Aufbau auf und kann eine Kantenlänge entsprechend der Rahmenkomponente 20 aus Figur 2 aufweisen. Auch in der Widerlagerkomponente 30 ist eine Öffnung 31 vorgesehen, die dazu dient, eine Halteinrichtung, auf der das Substrat angeordnet ist, allseitig zu umgeben, so dass die Halteeinrichtung seitlich von der Widerlagerkomponente 20 eingefasst ist. In den Eckbereichen der Widerlagerkomponente 30 sind vier Fixierelemente 32 in Form von Fixierbolzen vorgesehen. Diese Fixierelemente 32 wirken mit den Aussparungen 22 der Rahmenkomponente 20 aus Figur 2 zusammen, so dass die Rahmenkomponente 20 beim in Verbindungbringen mit der Widerlagerkomponente 30 in Position gehalten wird. Bevorzugt ist vorgesehen, dass die Rahmenkomponente 20 lösbar mit der Widerlagerkomponente 30 verbunden ist, wobei die Rahmenkomponente 20 lösbar auf der Widerlagerkomponente 30 aufgelegt ist. Zusätzlich ist in Figur 2 die Federkomponente 40 gezeigt, die aus einer Anzahl von Federelementen 41 gebildet ist.

Die Federelemente 41 können auf unterschiedliche Weise ausgebildet sein. Eine bevorzugte Ausführungsform hierfür ist in Figur 4 dargestellt. Das dort dargestellte Federelement 41 ist in Form eines federnden Druckstücks ausgebildet. Das so ausgebildete Federelement 41 besteht demnach aus einem Gehäuse 42, in dem eine Feder 43 angeordnet ist. Am oberen Ende der Feder 43 ist eine Kugel 44 vorgesehen. Wird auf die Kugel 44 eine Kraft F ausgeübt, wird die Kugel 44 nach innen in das Gehäuse 42 gepresst, wodurch die darunter liegende Feder 43 zusammengedrückt wird. Die Feder 43 erzeugt dadurch eine elastische Rückstellkraft, die die Kugel 44 in deren Ausgangslage zurückbefördern will. Wird die Kraft F aufgehoben, entspannt sich die Feder 43 und die Kugel 44 wird in deren Ausgangslage zurückbefördert.

Die grundlegende Funktionsweise der in den Figuren 1 bis 4 dargestellten Aufbringvorrichtung 10 ist wie folgt. Wird auf die Rahmenkomponente 20 eine Kraft F ausgeübt, wie schematisch in Figur 1 dargestellt ist, wird die Rahmenkomponente 20 nach unten gedrückt. Dadurch werden die Federelemente 41 der Federkomponente 40 aktiviert, so dass in der Federkomponente eine elastische Rückstellkraft R erzeugt wird, die schematisch in Figur 1 dargestellt ist, und die der aufgebrachten Kraft F entgegenwirkt. Diese elastische Rückstellkraft R ist somit bestrebt, die Rahmenkomponente 20 in deren Ausgangslage zurück zu befördern. Damit die elastische Rückstellkraft R überhaupt erzeugt werden kann, ist unterhalb der Federkomponente 40 die Widerlagerkomponente 30 vorgesehen, die einen stabilisierenden Effekt ausübt und als Widerlager für die Federkomponente 40 fungiert. Wird die auf die Rahmenkomponente 20 ausgeübte Kraft F zurückgenommen, entspannt sich die Federkomponente 40, wobei sich insbesondere die Federelemente 41 entspannen, und die Rahmenkomponente 20 kehrt in die Ausgangslage zurück.

In Figur 5 ist eine Aufbringvorrichtung 10 dargestellt, die in Form einer Folie ausgebildet ist. Entweder handelt es sich um eine einteilige Folie, bei der die Rahmenkomponente, die Widerlagerkomponente und die Federkomponente in der Folie rein funktional ausgebildet sind. Oder aber die als Folie ausgebildete Aufbringvorrichtung 10 weist einen schichtförmigen Aufbau auf, wobei die Rahmenkomponente, die Widerlagerkomponente und die Federkomponente jeweils durch eine Folienschicht ausgebildet sind, und die einzelnen Folienschichten zur Gesamtfolie zusammengefügt sind.

In einem solchen Fall kann die Aufbringvorrichtung 10 bevorzugt mehrere hintereinander angeordnete oder ausgebildete Rahmenkomponenten mit dazugehörigen Widerlagerkomponenten und Federkomponenten aufweisen. In der Figur 5 ist dies durch eine Reihe von hintereinander ausgebildeten Öffnungen 21 der Rahmenkomponenten der Aufbringvorrichtung 10 verdeutlicht.

Die auf diese Weise ausgebildete Aufbringvorrichtung 10 kann in einem Vorab-Schritt zunächst mit einer Folie 90 verbunden werden, wobei in einem späteren Aufbringprozess dann die Gesamteinheit "Folie 90 und Aufbringvorrichtung 10" zum Einsatz kommt. Diese Gesamteinheit kann beispielsweise in Form von Folienrollen oder Folienbahnen für das Aufbringen von Folien auf das Substrat verwendet werden.

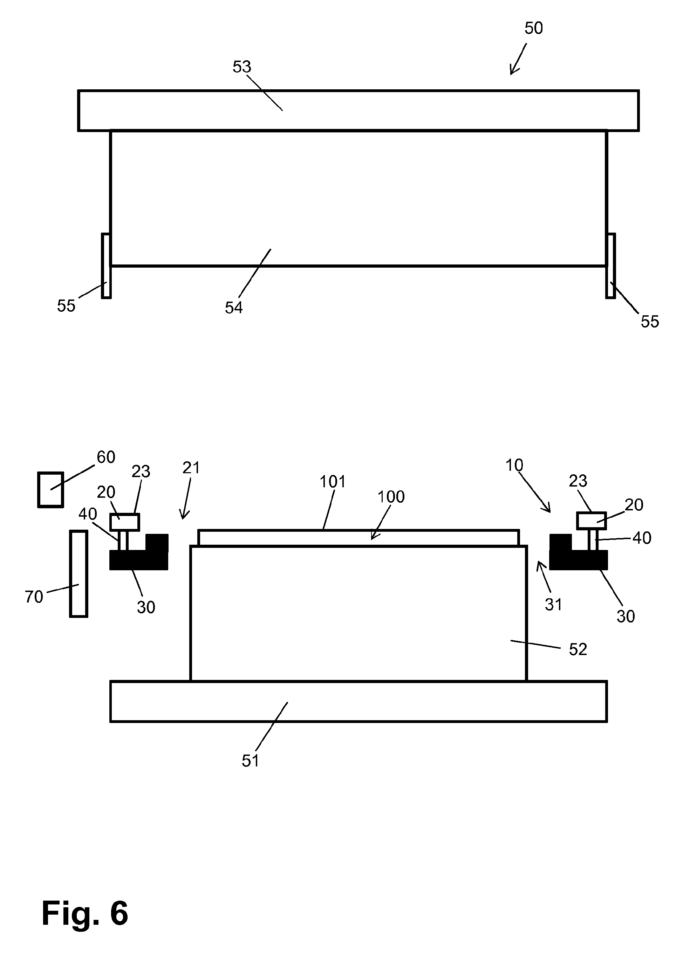

Die insbesondere in den Figuren 1 bis 5 dargestellte und vorstehende beschriebene Aufbringvorrichtung 10 wird bevorzugt in einer Bearbeitungsvorrichtung 50 zum Behandeln oder Bearbeiten von Substraten 100 in Form von Wafern eingesetzt, die in Figur 6 dargestellt ist.

Die Bearbeitungseinrichtung 50 weist einen unteren Bearbeitungstisch 51 auf, auf dem ein Substrat 100 in Form eines Wafers behandelt oder bearbeitet wird. Hierzu weist der untere Bearbeitungstisch 51 eine untere Halteeinrichtung 52 zur Aufnahme des Substrats 100 auf. Während der Behandlung oder Bearbeitung des Substrats 100 befindet sich dieses zunächst auf der unteren Halteeinrichtung 52. Bei der unteren Halteeinrichtung 52 handelt es sich bevorzugt um einen so genannten Chuck.

Umgeben, das heißt seitlich eingefasst ist das auf der unteren Halteeinrichtung 52 angeordnete Substrat 100 von der in den Figuren 1 bis 5 dargestellten und vorstehenden beschriebenen Aufbringvorrichtung 10, bestehend aus der Rahmenkomponente 20, der Widerlagerkomponente 30 und der dazwischen befindlichen Federkomponente 40. Wie in Figur 6 deutlich zu erkennen ist, befinden sich das Substrat 100 und die untere Halteeinrichtung 52 innerhalb der Öffnungen 21 und 31 der Rahmenkomponente 20 sowie der Widerlagerkomponente 30.

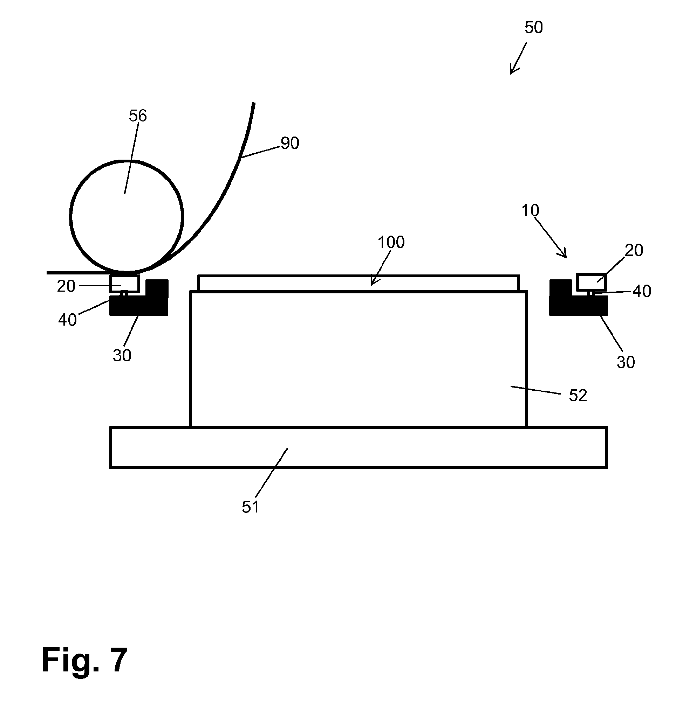

Anhand der Figur 6 lässt sich auch die grundlegende Funktionsweise der Aufbringvorrichtung 10 verdeutlichen. Ziel der Aufbringvorrichtung 10 ist es, dass eine Folie möglichst glatt und faltenfrei auf dem Substrat 100 aufgebracht werden kann. Während des Aufbringprozesses, der anhand der Figuren 7 bis 9 weiter unten näher erläutert wird, wird eine Folie sowohl auf der Rahmenkomponente 20 als auch auf dem Substrat 100 aufgebracht. Nun lässt sich nicht vermeiden, dass die Substrate 100 jeweils unterschiedliche Dicken aufweisen. Um dennoch ein gleichmäßiges, faltenfreies Aufbringen der Folie auf dem Substrat 100 und auch auf der Rahmenkomponente 20 zu gewährleisten, ist es erforderlich, dass das Niveau des Substrats 100, insbesondere das Niveau von dessen oberer Oberfläche 101, und das Niveau der Rahmenkomponente 20, insbesondere das Niveau von deren oberen Oberfläche 23 während des Aufbringprozesses der Folie in einer Ebene liegen. Das Aufbringen der Folie erfolgt in einer an sich bereits bekannten Weise, nämlich dergestalt, dass eine Druckkraft auf die aufzubringende Folie aufgebracht wird. Diese Druckkraft bewirkt, dass die Rahmenkomponente 20 herabgedrückt wird, und zwar soweit, bis das Niveau des Substrats 100 erreicht ist. Während des Aufbringprozesses befinden sich nun die Rahmenkomponente 20 und das Substrat 100 auf demselben Niveau. Wird die ausgeübte Druckkraft zurückgefahren, entspannt sich die Federkomponente 40 wieder und die Rahmenkomponente 20 kann in ihre ursprüngliche Ausgangslage zurückkehren. Um Substrate 100 mit möglichst vielen unterschiedlichen Dicken bearbeiten zu können, ist bevorzugt vorgesehen, dass sich das Niveau der Rahmenkomponente 20 im Ausgangszustand ausreichend weit oberhalb des Niveaus der zu bearbeitenden Substrate 100 befindet.

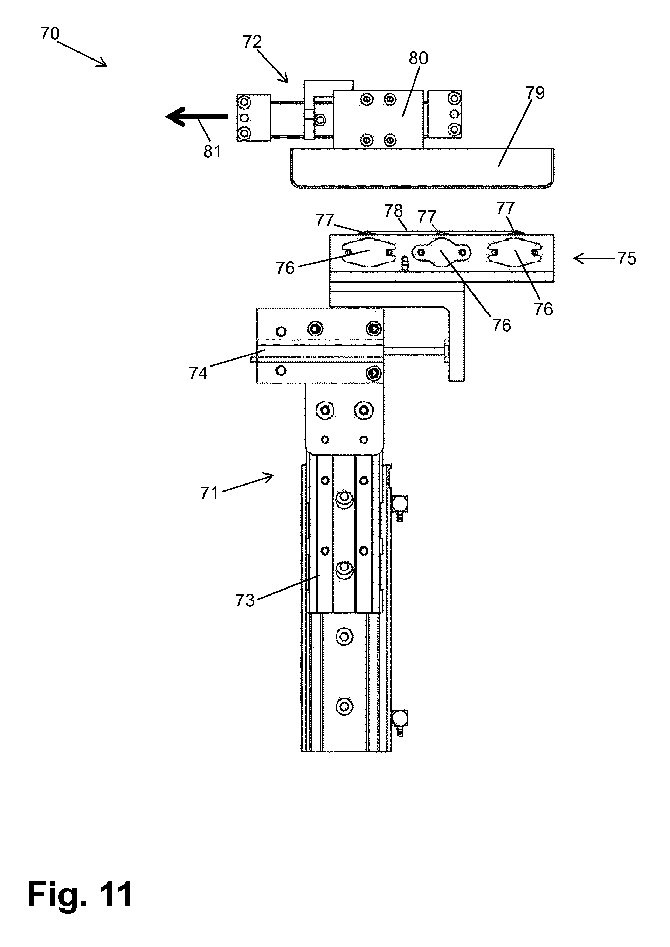

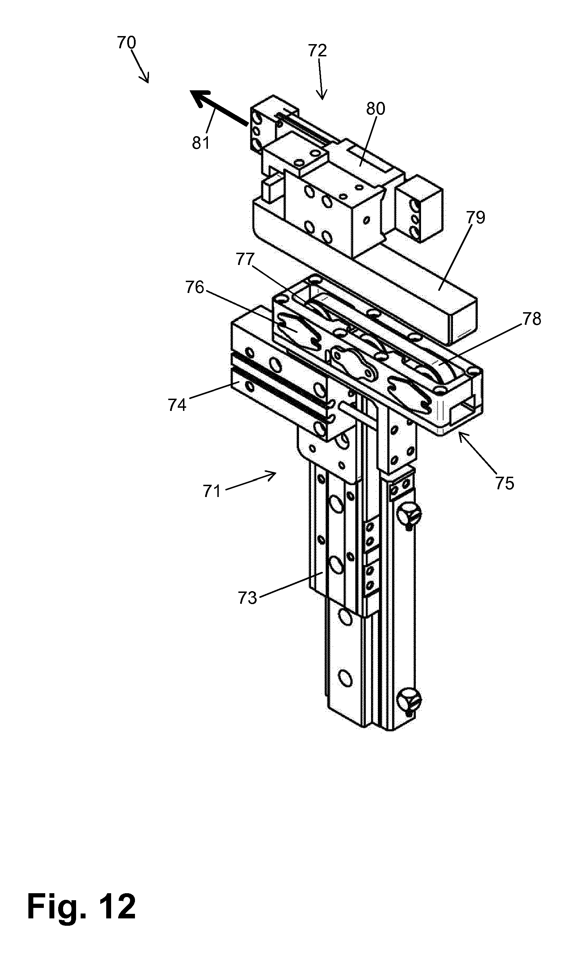

Weiterhin weist die Bearbeitungsvorrichtung 50 eine Sensoreinrichtung 60 zur Messung der Folienbreite, die als Ultraschall-Kantensenor ausgebildet sein kann, sowie eine Einrichtung 70 zum Folien-Querstrecken auf. Die Einrichtung 70 zum Folien-Querstrecken wird anhand der Figuren 11 und 12 weiter unten in größerem Detail beschrieben.

Neben dem unteren Bearbeitungstisch 51 weist die Bearbeitungsvorrichtung 50 zudem einen zweiten, oberen Bearbeitungstisch 53 mit einer oberen Halteeinrichtung 54 auf, wobei die obere Halteeinrichtung 54 ebenfalls als Chuck ausgebildet ist. An der oberen Halteeinrichtung 54 befindet sich wenigstens eine Befestigungseinrichtung 55 zum Befestigen der Rahmenkomponente 20 an der oberen Haltevorrichtung 54. Die Befestigungseinrichtung 55 kann beispielsweise als Klemmelement ausgebildet sein.

Da die Rahmenkomponente 20 lösbar an der Widerlagerkomponente 30 angeordnet ist, ist es möglich, dass die Rahmenkomponente 20 während der Bearbeitungsprozedur von der Widerlagerkomponente 30 abgehoben und an die obere Halteeinrichtung 54 zur weiteren Bearbeitung übergeben und dort über die Befestigungseinrichtung 55 an der oberen Halteeinrichtung 54 gehalten wird.

Dieser Vorgang wird im Folgenden näher erläutert, indem anhand der Figuren 7 bis 10 ein Bearbeitungsverfahren unter Verwendung der in Figur 6 dargestellten Bearbeitungsvorrichtung 50 beschrieben wird.

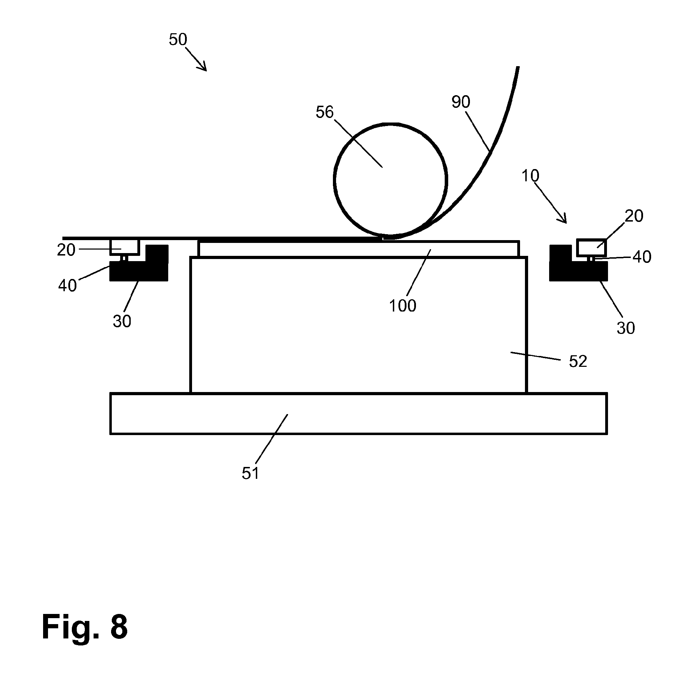

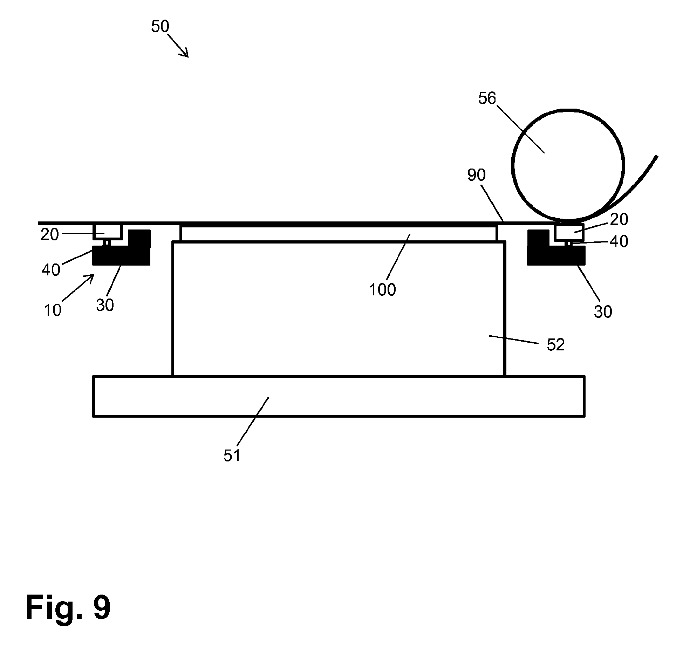

Bei dem in den Figuren 7 bis 10 dargestellten Bearbeitungsverfahren soll eine Folie 90 auf dem Substrat 100 und auch auf der Rahmenkomponente 20 der Aufbringvorrichtung 10 aufgebracht werden. Dazu verfügt die Bearbeitungsvorrichtung 50 über eine Druckrolle 56. Über die Druckrolle 56 wird eine Druckkraft erzeugt, mittels derer die Folie 90 zunächst auf ein Ende der Rahmenkomponente 20 aufgerückt wird, die ja das Substrat 100 von allen Seiten umgibt (Figur 7). Die Druckrolle 56 verfährt weiter über die Rahmenkomponente 20, so dass die Folie 90 auch auf dem Substrat 100 aufgebracht wird (Figur 8). Da die Rahmenkomponente 20 über die Federkomponente 40 federnd auf der Widerlagerkomponente 30 abgestützt ist, wird die Rahmenkomponente 20 über die Druckrolle 56 dabei soweit nach unten gedrückt, bis deren Niveau auf derselben Höhe liegt wie das Niveau des Substrats 100. Am Ende des Aufbringprozesses (Figur 9) hat die Druckrolle 56 das andere Ende der Rahmenkomponente 20 erreicht. Es ist nunmehr eine Einheit entstanden, bestehend aus Rahmenkomponente 20 und Substrat 100, wobei das Substrat 100 über die Folie 90 an der Rahmenkomponente 20 angeheftet ist.

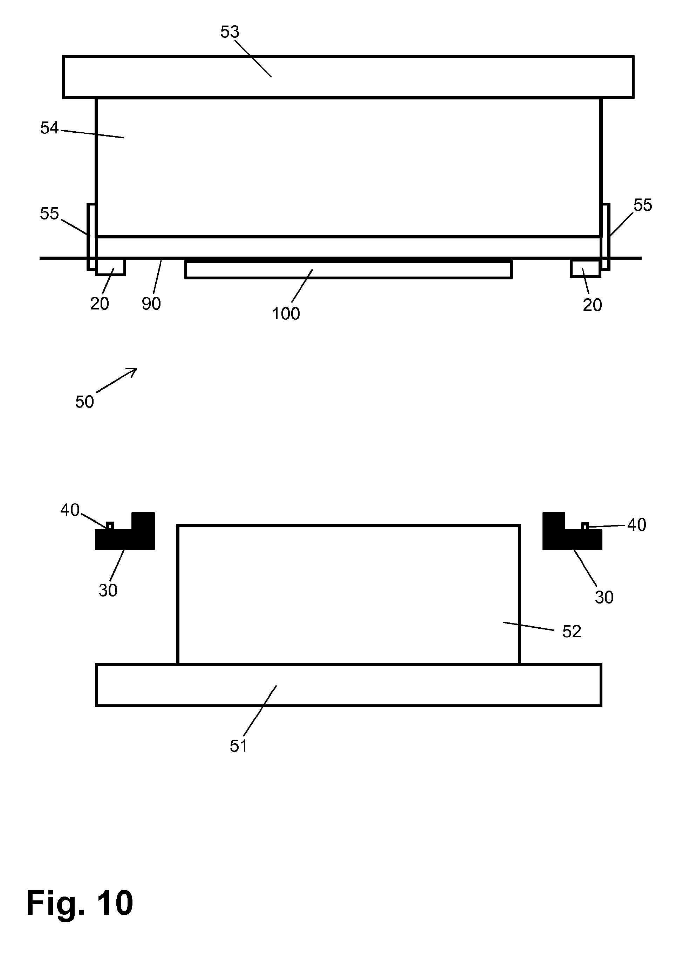

Nach Beendigung des Aufbringprozesses kann die Einheit, bestehend aus Rahmenkomponenten 20 und Substrat 100, wobei das Substrat 100 über die Folie 90 an der Rahmenkomponente 20 angeheftet ist, einem weiteren Bearbeitungsschritt zugeführt werden, wie dies in Figur 10 angedeutet ist. Da die Rahmenkomponente 20 lösbar an der Widerlagerkomponente 30 angeordnet ist, kann diese von der Widerlagerkomponente 30 und damit von der unteren Halteeinrichtung 52 abgehoben und zu der oberen Halteeinrichtung 54 überführt werden. Über die Befestigungseinrichtungen 55 kann die Rahmenkomponente 20 an der oberen Halteeinrichtung 54 angeordnet werden und dort einem weiteren Bearbeitungsschritt unterzogen werden.

Wie im Zusammenhang mit Figur 6 schon angedeutet wurde, weist die Bearbeitungsvorrichtung 50 auch eine Einrichtung 70 zur Folien-Querstreckung auf, die im Zusammenhang mit den Figuren 11 und 12 nun näher erläutert wird.

Die Einrichtung 70 weist eine untere Klemmeinrichtung 71 und eine obere Klemmeinrichtung 72 auf. Die untere Klemmeinrichtung 71 weist einen Linearzylinder 73 für die Klemmbewegung sowie einen Linearzylinder 74 für eine Querbewegung auf. Weiterhin ist eine untere Klemmung 75 vorgesehen. Diese verfügt über eine Anzahl von Rotationsdämpfereinrichtungen 76 mit entsprechenden Riemenscheiben 77 und einem Synchronriemen 78. Die obere Klemmeinrichtung 72 verfügt über eine obere Klemmung 79 mit einer Linearführung 80 und einer Zugfeder 81.

Die Bearbeitungsvorrichtung 50 muss beispielsweise 500 mm breite Folie handhaben, welche am Ende des Bearbeitungsprozesses ausgeschnittene Löcher mit 400 mm Durchmesser aufweisen kann. Nachdem die Folie in der wie vorstehend beschriebenen Weise auf dem Substrat 100 und auch der Rahmenkomponente 20 angeordnet worden ist, kann diese Einheit "Rahmenkomponente 20, Substrat 100, Folie 90" einem weiteren Bearbeitungsprozess zugeführt werden. Am Ende dieses Bearbeitungsprozesses kann vorgesehen sein, dass das Substrat 100 aus der Rahmenkomponente 20 ausgeschnitten wird. Zurück bleibt dann die Folie 90 mit den vorgenannten ausgeschnittenen Löchern, die zusätzlich auch von der Rahmenkomponente 20 abgelöst wird. Insbesondere wenn die aufgebrachte Folie 90 kontinuierlich über eine Folienrolle abgewickelt wird, müssen die nicht mehr benötigten Folienteile mit den ausgeschnittenen Löchern weiter transportiert werden. Wenn an einer Folie mit einem so großen Loch gezogen wird, engt sie sich noch stärker ein als es schon ohne Loch der Fall ist.

Um diesem Effekt entgegenzuwirken, wird die Folie mit Hilfe von Breitstreckwalzen und der Einrichtung 70 zum Folien-Querstrecken auf möglichst voller Breite gehalten. Dies ist notwendig, damit die Folie faltenfrei auf das Substrat 100 laminiert werden kann und dass der Folienrest sauber mit möglichst wenig Falten auf eine Zielrolle aufgewickelt werden kann.

Mit Hilfe der Einrichtung 70 zum Folien-Querstrecken kann die Folie 90, auch während sie stillsteht, auch quergestreckt und in dem gedehnten Zustand wieder geklemmt werden.

Die untere Klemmeinrichtung 71 und die obere Klemmeinrichtung 72 klemmen die Folie zwischen den als Backen ausgebildeten Klemmungen 75 und 79 und ziehen diese quer zur Bewegungsrichtung. Damit sich die Folie nicht durch die Zwangsführung in den Klemmungen 75, 79 plastisch überdehnt, kann die Kraft mittels Druckbegrenzung, beispielsweise von Pneumatikzylindern erreicht werde. Die obere Klemmung 79 der Einrichtung 70 ist insbesondere antihaftbeschichtet, die Folie lässt sich auf ihr recht reibungsfrei verschieben. Die untere Klemmung 75, welche die Klebende Seite der Folie berührt, ist bevorzugt der Synchronriemen 78, welcher über die Riemenscheiben 77 umgelenkt wird. Die Riemenscheiben 77 sind weder fixiert noch frei drehend, sondern auf den Rotationsdämpfereinrichtungen 76 montiert. Durch diese Elemente kann sich der Synchronriemen 78 bei der Querstreckbewegung nur so leicht und nur so weit verschieben, bis eine Querspannung der Folie erreicht wird, die den elastischen Bereich noch nicht überschreitet.

Die Klemmbewegung wird über die untere Klemmung 75, beispielsweise mittels Pneumatikzylinder, ausgeführt. Über den Luftdruck kann man die Klemmkraft steuern. Die Querbewegung wird ebenso über die untere Klemmung 75 mittels Pneumatikzylinder ausgeführt. Die obere Klemmung 78 wird auf Linearführungen 80 in Querrichtung geführt und in den anderen Achsrichtungen fixiert. Die Rückstellbewegung nach innen übernimmt bevorzugt die Zugfeder 81.

### Bezugszeichenliste

- 10: Vorrichtung zum Aufbringen einer Folie auf einem Substrat (Aufbringvorrichtung)
- 20: Rahmenkomponente
- 21: Öffnung
- 22: Aussparung
- 23: Obere Oberfläche
- 30: Widerlagerkomponente
- 31: Öffnung
- 32: Fixierelement
- 40: Federkomponente
- 41: Federelement
- 42: Gehäuse
- 43: Feder
- 44: Kugel
- 50: Bearbeitungsvorrichtung
- 51: Unterer Bearbeitungstisch
- 52: Untere Halteeinrichtung
- 53: Oberer Bearbeitungstisch
- 54: Obere Halteeinrichtung
- 55: Befestigungseinrichtung
- 56: Druckrolle
- 60: Sensoreinrichtung zur Messung der Folienbreite
- 70: Einrichtung zur Folien-Querstreckung
- 71: Untere Klemmeinrichtung
- 72: Obere Klemmeinrichtung
- 73: Linearzylinder für Klemmbewegung
- 74: Linearzylinder für Querbewegung
- 75: Untere Klemmung
- 76: Rotationsdämpfereinrichtung
- 77: Riemenscheibe
- 78: Synchronriemen
- 79: Obere Klemmung
- 80: Linearführung
- 81: Zugfeder
- 90: Folie
- 100: Substrat (Wafer)
- 101: Obere Oberfläche des Substrats
- F: Kraft
- R: Rückstellkraft

## Patentansprüche

1. Vorrichtung (10) für das Aufbringen einer Folie (90) auf einem Substrat (100), aufweisend eine Rahmenkomponente (20), die derart bereitgestellt ist, dass die Rahmenkomponente (20) in der Lage ist, mit der aufzubringenden Folie (90) zusammenzuwirken, eine Widerlagerkomponente (30), die derart bereitgestellt ist, dass sie in der Lage ist, ein Widerlager für die Rahmenkomponente (20) zu bilden oder eine Widerlagerfunktion in Bezug auf die Rahmenkomponente (20) auszuüben, sowie eine Federkomponente (40), die derart bereitgestellt ist, dass sie in der Lage ist, in Bezug auf die Rahmenkomponente (20) eine elastische Rückstellkraft (R) auszuüben.

2. Aufbringvorrichtung nach Anspruch 1, **dadurch gekennzeichnet, dass** die Federkomponente (40) zwischen der Rahmenkomponente (20) und der Widerlagerkomponente (30) angeordnet oder ausgebildet ist.

3. Aufbringvorrichtung nach Anspruch 1 oder 2, **dadurch gekennzeichnet, dass** die Rahmenkomponente (20) als Rahmenelement, insbesondere als Rahmenplatte ausgebildet ist, und/oder dass die Widerlagerkomponente (30) als Widerlagerelement, insbesondere als Widerlagerplatte oder als Vorspanneinrichtung, ausgebildet ist, und/oder dass die Federkomponente (40) als wenigstens ein Federelement (41) ausgebildet ist.

4. Aufbringvorrichtung nach einem der Ansprüche 1 bis 3, **dadurch gekennzeichnet, dass** die Federkomponente (40) an der Rahmenkomponente (20) angeordnet oder darin/daran ausgebildet ist, und/oder dass die Federkomponente (40) an Widerlagerkomponente (30) angeordnet oder darin/daran ausgebildet ist, und/oder dass die Federkomponente (40) ein eigeständiges Bauteil ist, das zwischen der Rahmenkomponente (20) und der Widerlagerkomponente (30) angeordnet ist.

5. Aufbringvorrichtung nach einem der Ansprüche 1 bis 4, **dadurch gekennzeichnet, dass** die Federkomponente (40) als wenigstens ein Federelement (41) zum Erzeugen elastischer Rückstellkräfte, insbesondere als elastisches Element und/oder Druckstück und/oder Luftspalt, ausgebildet ist.

6. Aufbringvorrichtung nach einem der Ansprüche 1 bis 5, **dadurch gekennzeichnet, dass** die Rahmenkomponente (20) eine oder mehrere Aussparungen (22) aufweist.

7. Aufbringvorrichtung nach einem der Ansprüche 1 bis 6, **dadurch gekennzeichnet, dass** die Widerlagerkomponente (30) wenigstens ein Fixierelement (32) zum Fixieren der Rahmenkomponente (20) aufweist.

8. Aufbringvorrichtung nach einem der Ansprüche 1 bis 7, **dadurch gekennzeichnet, dass** die Rahmenkomponente (20) wenigstens eine Befestigungseinrichtung (55) zum Befestigen der Rahmenkomponente (20) an einer Halteeinrichtung (52, 54) aufweist.

9. Aufbringvorrichtung nach einem der Ansprüche 1 bis 8, **dadurch**
**gekennzeichnet dass** die Rahmenkomponente (20) und/oder die Widerlagerkomponente (30) wenigstens eine Öffnung (21, 31) aufweist/aufweisen, die derart bereitgestellt ist, dass sie in der Lage ist, eine Halteeinrichtung (52) mit einem darauf befindlichen Substrat (100), auf dem die Folie (90) aufgebracht werden soll, zu umgeben.

10. Bearbeitungsvorrichtung (50) zum Bearbeiten eines Substrats (100), mit einem Bearbeitungstisch (51, 53), der eine Halteeinrichtung (52, 54) zur Aufnahme eines Substrats (100) aufweist, und mit einer Aufbringvorrichtung (10) zum Aufbringen einer Folie (90) auf das Substrat (100) nach einem der Ansprüche 1 bis 9.

11. Bearbeitungseinrichtung nach Anspruch 10, **dadurch gekennzeichnet, dass** diese wenigstens eine Druckrolle (56) zum Übertragen einer Druckkraft auf die aufzubringende Folie (90) aufweist.

12. Bearbeitungseinrichtung nach Anspruch 10 oder 11, **dadurch gekennzeichnet,**
**dass** diese eine Einrichtung (70) zum Folien-Querstrecken aufweist.

13. Bearbeitungseinrichtung nach Anspruch 12, **dadurch gekennzeichnet, dass**
die Einrichtung (70) zum Folien-Querstrecken wenigstens eine Rotationsdämpfereinrichtung (76) aufweist.

14. Bearbeitungseinrichtung nach einem der Ansprüche 10 bis 13, **dadurch**
**gekennzeichnet, dass** diese wenigstens eine Sensoreinrichtung (60) zur Messung der Folienbreite aufweist.

15. Verfahren zum Aufbringen einer Folie (90) auf ein Substrat (100) unter
Verwendung einer Bearbeitungseinrichtung (50) nach einem der Ansprüche 10 bis 14, **gekennzeichnet durch** folgende Schritte:
a) Ein Substrat (100) wird auf der Halteeinrichtung (52) des Bearbeitungstisches (51) aufgebracht, wobei die Halteeinrichtung (52) mit dem darauf befindlichen Substrat (100) von der Aufbringvorrichtung (10) umgeben ist oder wird;
b) Eine Folie (90) wird auf die Rahmenkomponente (20) der Aufbringvorrichtung (1) und das Substrat (100) aufgebracht;
c) Es wird eine Druckkraft, insbesondere über eine Druckrolle (56), auf die Rahmenkomponente (20) und das Substrat (100) übertragen, um die Folie (90) an das Substrat (100) und die Rahmenkomponente (20) anzudrücken;
d) **Durch** die übertragene Druckraft wird in der Federkomponente (40) der Aufbringvorrichtung (10) eine elastische Rückstellkraft (R) erzeugt und auf die Rahmenkomponente (20) der Aufbringvorrichtung (10) ausgeübt.
